# EUROPEAN PATENT SPECIFICATION

(11) **EP 2 030 226 B1**
(45) Date of publication and mention of the grant of the patent: **24.02.2016**
(21) Application number: 07746969.0
(22) Date of filing: 18.06.2007
(51) Int. Cl.: H01L 21/3065, H01J 37/32

(54) **PLASMA ETCHING CHAMBER**
PLASMAÄTZKAMMER
CHAMBRE DE GRAVURE AU PLASMA

(30) Priority: 20.06.2006 KR 20060055549
(43) Date of publication of application: 04.03.2009
(73) Proprietor: Sosul Co., Ltd., Yongin City, Gyeonggi Province 449-881 (KR)
(72) Inventor: CHUNG, Seung-Hyun, Gyeonggi Province 449-881 (KR); KIM, Geun-Ho, Gyeonggi Province 449-881 (KR)
(74) Representative: Köhler, Walter
(86) International application number: PCT/KR2007/002935
(87) International publication number: WO 2007/148897

(56) References cited:
- EP-A2- 1 170 777
- JP-A- 58 078 428
- US-A1- 2003 151 371
- US-A1- 2006 032 736
- US-B1- 6 259 592
- US-B1- 6 527 911
- US-B2- 6 716 727
- US-B2- 6 962 644

## Description

### Technical Field

The present invention relates to an apparatus for dry etching a wafer, and more particularly, to a plasma etching chamber of plasma etching a film remaining on an edge of a semiconductor wafer and particles deposited at a periphery thereof.

### Background Art

A film stacked on a surface of a wafer is typically removed by a plasma etching. However, during the process, as the stacked film remains, particles are generated. The particles are not completely removed and some of the particles are deposited at an edge of the wafer.

In order to completely remove the particles deposited at the edge of the wafer, it has been developed a plasma etching chamber wherein upper and lower electrodes having a ring shape are disposed above and below a wafer chuck on which the wafer is put, a voltage is applied to both the electrodes while supplying a reaction gas to the edge of the wafer and plasma is thus generated with which the particles at the edge are removed.

The known plasma etching chamber comprises a housing having a space isolated from an outside, a ring-shaped upper electrode that is disposed at an upper part in the housing to be moveable vertically, a gas distribution plate that is located on a center of the upper electrode and forms a passage of a reaction gas, a wafer chuck vertically operated so that it receives a wafer loaded through a gate and a ring-shaped lower electrode that is disposed at a periphery.

The plasma etching is carried out while maintaining a gap between the gas distribution plate and the wafer surface to be 0.1∼0.6 mm (typically, 0.35 mm). Since the error of the gap is managed in a sever condition of 0.05 mm unit, the gap should be finely adjusted in a very precise manner. In addition, the center of the wafer should not be deviated from a center of the wafer chuck and not be eccentrically loaded.

In the mean time, in the plasma etching chamber, the reaction by-products are deposited at the upper and lower electrodes and the periphery of the assembly during the operation. Accordingly, the chamber is periodically disassembled so as to clean.

In the known plasma etching chamber, the upper and lower electrodes are independently driven vertically and an insulator to support the upper electrode is supported through a center of an upper cover of the housing. Accordingly, whenever disassembling and re-assembling the chamber, an alignment of the upper electrode and the assembly adjacent thereto is apt to be varied. Thereby, when disassembling and assembling the plasma etching chamber, it is caused a change in the gap between the upper electrode and the wafer surface or a mis-alignment of the wafer. As a result, the gap or alignment should be precisely set again every time.

Furthermore, it is necessary to check with naked eyes whether the wafer, which is supplied into the housing and put on an upper surface of the wafer chuck, is correctly aligned, prior to the plasma etching. However, since the conventional plasma etching chamber is provided at the center thereof with a vertically moving rod so as to vertically move the upper electrode, it is impossible to check the wafer chuck from the above with naked eyes and thus to monitor the alignment of the wafer from the outside.

In addition, in the conventional plasma etching chamber, the wafer may be damaged in the course of chucking and etching the wafer into the chamber and de-chucking the etched wafer.

The wafer chuck is provided with a separate mechanism for chucking and de-chucking the wafer. An example thereof is a vacuum chuck that vacuum-sucks a lower surface of the wafer when loading the wafer. In addition, in etching, the charges are accumulated on the surface of the wafer due to the plasma. The charges may shock the wafer surface to damage the wafer. In particular, a gate film exhibits a property that it is easily damaged by the charges accumulated on the wafer.

In addition, when applying poly-imide as the wafer chuck, there occurs no slip when loading and unloading the wafer. However, the poly-imide is apt to be easily damaged by the plasma, so that it is difficult to apply it to the wafer chuck.

### Disclosure of Invention

### Technical Problem

Accordingly, the present invention has been made to solve the above problems. An object of the invention is to provide a plasma etching chamber having a structure in which an alignment of upper and lower electrodes are not varied even though a cover of a housing is opened/closed so as to clean and repair the chamber.

Still another object of the invention is to provide a plasma etching chamber capable of eliminating charges to prevent a damage of a wafer by introducing an electrostatic chuck to a wafer chuck, the charges being accumulated on the wafer due to the plasma when etching.

Yet still another object of the invention is to provide a plasma etching chamber capable of preventing a slip when loading a wafer on a wafer chuck.

Another object of the invention is to provide a plasma etching chamber having a structure capable of automatically controlling an etching time of a wafer to suppress an over-etching and allowing in-situ monitoring.

Document EP 1 170 777 A2 discloses a plasma etching chamber. The plasma etching chamber comprises a housing providing a space isolated from an outside and having an upper surface opened and closed by a cover; an upper electrode assembly mounted in the housing with being separated from the cover so that its position is maintained when opening and closing the cover; a lower electrode assembly mounted below the upper electrode assembly to be moveable vertically in the housing, a wafer resting on the lower electrode assembly; and means for moving the lower electrode assembly vertically wherein the lower electrode assembly comprises a wafer chuck on which the wafer rests.

Document US 2006/0032736 A1 discloses a vacuum chamber with a chamber wall defining a main cavity with an opening. A cover across the opening is provided wherein the cover comprises a first section adjacent to the main cavity and a second section opposite to the main cavity. Gas is evacuated from the main cavity through an exhaust port so that the second section deforms. The pocket is used to reduce the deformation of the first section.

Document US 2003/151371 A1 discloses a plasma processing chamber configures to receive a gas. The plasma processing chamber comprises a first powered electrode configured to receive a workpiece with the first powered electrode having a first electrode area; a power generator operatively coupled to the first powered electrode and configured to communicate power to the first power electrode; and a second electrode disposed at a distance from the first electrode, with the first powered electrode and the second powered electrode configured to convert gas into plasma with the second electrode having a second electrode area; and a ground extension adjacent the first powered electrode and surrounding the first powered electrode.

Document US 6,259,592 B1 discloses an apparatus for retaining a workpiece on a workpiece support. The apparatus comprises a workpiece support layer disposed on the workpiece support. The workpiece support layer is fabricated of a base material and a dopant selected from the group consisting of carbon and a polymer, wherein a resistivity of said workpiece support layer is less than a resistivity of the base material.

Document JP 58 078428 discloses a vacuum chamber wherein a gas inlet pipe for introducing a reactive gas and am exhaust port for exhausting reactive gas are formed within the vacuum chamber. Glass windows which are mounted opposing to the vacuum chamber in such a manner as sandwiching the region between the electrode within the vacuum chamber 1 are respectively provided with a light source and a light sensor which form a dust counter. As a light source, a halogen lamp is used and the light sensor is connected with a measuring instrument which processes a received optical signal. With a reactive ion etching apparatus thus configured, the number of ash-flies existing within the region between electrodes of the vacuum chamber can be easily measured before and after the etching process.

### Technical Solution

In order to achieve the above object, there is provided a plasma etching chamber comprising a housing providing a space isolated from an outside and having an upper surface opened/closed by a cover; an upper electrode assembly mounted in the housing with being separated from the cover so that its position can be maintained when opening and closing the cover; a lower electrode assembly mounted below the upper electrode assembly to be moveable vertically in the housing; and means for moving the lower electrode assembly vertically.

In addition, the lower electrode assembly comprises a wafer chuck on which the wafer rests and a ring-shaped lower electrode that is disposed at a periphery of the wafer chuck.

In addition, the wafer chuck is made of ceramics and has a space therein in which a center formed with poly-imide is accommodated.

In addition, a ring-shaped discharge electrode grounded via a switching means is mounted at an edge of the wafer chuck. Here, an electrostatic electrode to which power is applied through a DC generator is disposed in the center to chuck or de-chuck the wafer with electrostatic charges.

In addition, the plasma etching chamber may have an in-situ monitoring tool that is disposed in a vent passage of the housing and detects particles remaining in gases generated with the plasma etching. At this time, the in-situ monitoring tool may comprise a light-emitting part and a light-receiving part that are disposed to be opposite.

In addition, the upper electrode assembly may rest on a step formed on a side wall of the housing and may be fixed with an engagement means.

In addition, the vertically moving means comprises a shaft downwardly extending from the lower electrode assembly and protruding to an outside of the housing; a screw driven by a servo motor; a carrier vertically moving along the screw as the screw rotates; and a support rod connecting the shaft and the carrier.

In addition, a sealing may be interposed between the housing and the cover.

In addition, a bellows for maintaining an air-tight state may be further mounted to a periphery of the shaft.

In addition, in order to achieve the above objects, there is provided a plasma etching chamber comprising: a housing providing a space isolated from an outside and having an upper surface opened/closed by a cover; an upper electrode assembly mounted in the housing; a lower electrode assembly mounted to be moveable vertically below the upper electrode assembly in the housing, a wafer resting on the lower electrode assembly; means for moving the lower electrode assembly vertically; and a transparent observation window provided at a center of the upper electrode assembly and allowing an alignment of the wafer to be observed from the outside.

In addition, a transparent observation window may be further provided at a center of an upper surface of the housing.

In addition, a CCD camera may be further provided above the observation window formed on the center of the upper electrode assembly or on the center of the upper surface of the housing.

In addition, an alignment mark may be respectively formed on a center of the observation window and a center of the lower electrode assembly, so that an alignment of the upper and lower electrode assemblies can be checked according to whether the alignment marks are matched each other.

In addition, the alignment mark may be cross-shaped.

In addition, the transparent material may include quartz or sapphire.

### Advantageous Effects

As described above, the plasma etching chamber according to the invention has the advantages as follows.

Firstly, the upper electrode assembly in the housing is fixed at the position that is not affected by the opening/closing of the cover and the minute control is carried out so that the lower electrode assembly is relatively moved to form a gap necessary for the plasma etching. Accordingly, even though the cover is frequently opened and closed, the arrangement relationship of the upper and lower electrode assemblies is not changed. In addition, it is possible to carry out the super-precise control of sub-millimeter unit through the vertical movement of the lower electrode assembly.

Secondly, contrary to the prior art, the driving means for vertically moving the upper electrode assembly can be omitted, so that a simple structure can be realized.

Thirdly, since the upper electrode assembly can be easily removed through the cover, it is possible to easily clean the upper electrode body, the gas distribution plate and the wafer chuck after the use.

Fourthly, since the inside of the housing can be observed with naked eyes or a proper observation device such as CCD camera, as required, it is possible to eliminate the defective factor due to the mis-alignment before the etching.

Fifthly, the wafer chuck having the inside made of poly-imide and the periphery made of ceramics prevents the slip when loading the wafer, thereby realizing a precise alignment and preventing the wafer damage due to the plasma. In addition, since the inexpensive poly-imide is used, it is possible to reduce the manufacturing cost. 5

Sixthly, since it is possible to check whether the particles remain in the discharged gas and to analyze the components of the discharged gas with the in-situ monitoring tool and it is possible to automatically control the plasma etching time, the over-etching can be prevented.

### Brief Description of the Drawings

The above and other objects, features and advantages of the present invention will be more apparent from the following detailed description taken in conjunction with the accompanying drawings, in which:
FIG. 1 is a sectional side view of a plasma etching chamber
FIG. 2 is a plan view of a plasma etching chamber
FIG. 3 shows a CCD camera mounted to an observation window of a cover shown in FIG. 1;
FIG. 4 is a sectional side view of a plasma etching chamber showing a state after a wafer chuck is elevated;
FIG 5 is a sectional view of a wafer chuck according to the invention; and
FIG. 6 shows an example of an arrangement of an in-situ monitoring tool of a plasma etching chamber according to an embodiment of the invention.

### Mode for the Invention

Hereinafter, a preferred embodiment of the present invention will be described with reference to the accompanying drawings. In the following description of the present invention, a detailed description of known functions and configurations incorporated herein will be omitted when it may make the subject matter of the present invention rather unclear.

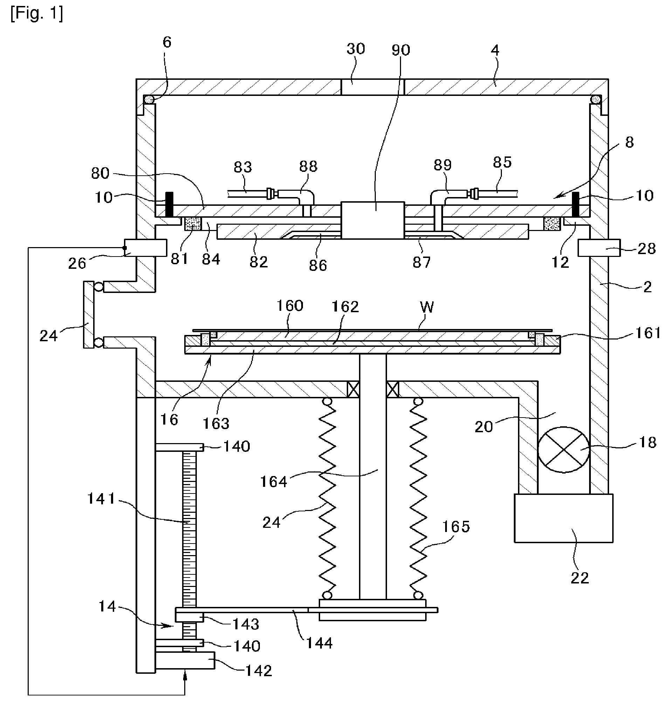

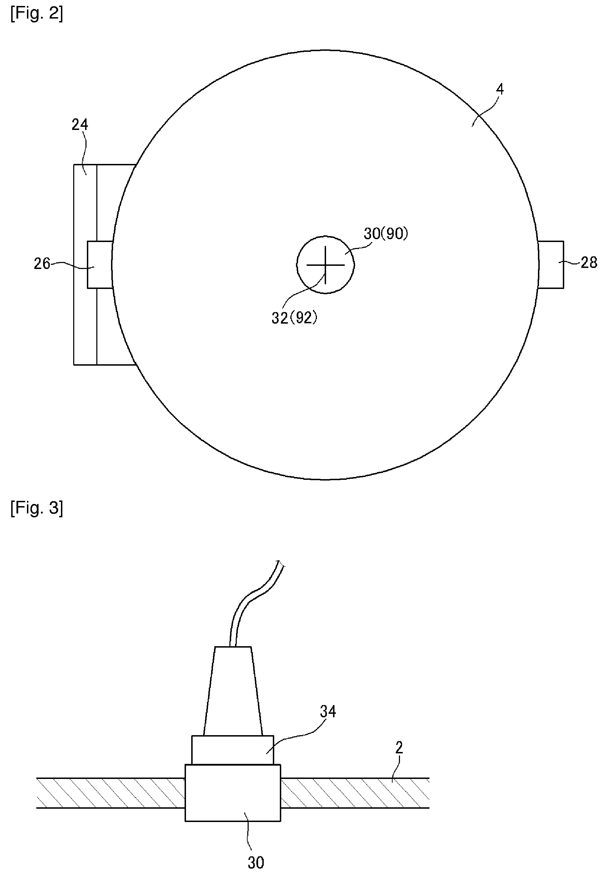

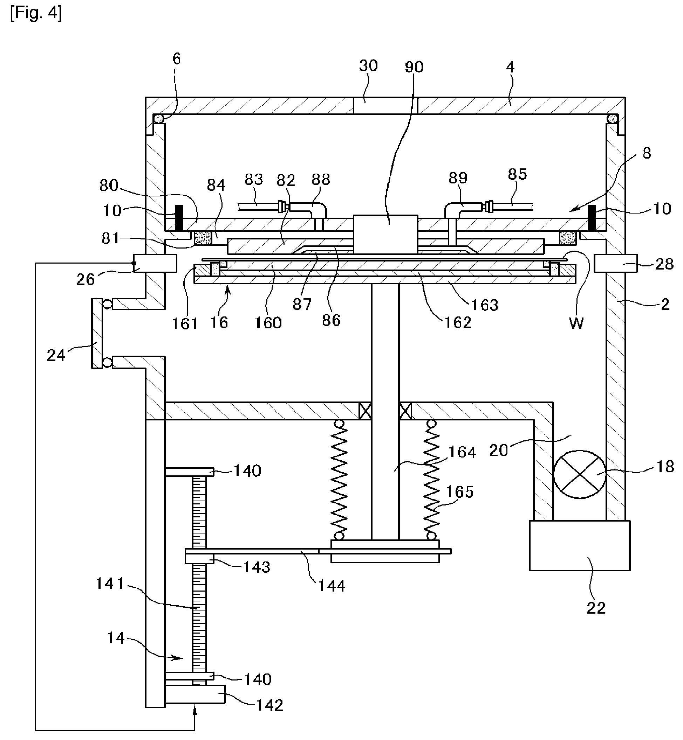

Fig. 1 is a sectional side view of a plasma etching chamber. Fig. 2 is a plan view of a plasma etching chamber. Fig. 3 shows that a CCD camera is mounted to an observation window of a cover shown in Fig. 1 and Fig. 4 is a sectional side view of a plasma etching chamber showing a state after a wafer chuck is elevated.

Referring to Fig. 1, a plasma etching chamber according comprises a housing providing a space isolated from an outside and having an upper surface opened/closed by a cover 4.

The cover 4 is connected to the housing 2 by a typical means. For example, it may be adopted a direct engagement manner using a bolt and a nut or a manner using a clamp means. A sealing 6 such as O-ring is preferably interposed between the housing 2 and the cover 4.

At an upper part of the housing 2, an upper electrode assembly 8 is disposed which is exposed to an outside when the cover 4 is opened. The upper electrode assembly 8 comprises an upper electrode body 80 made of a conductor detachably mounted in the housing 2, an upper electrode 81 fixedly attached to a bottom surface of the upper electrode body 80 and a gas distribution plate 82 located at an inner side thereof and made of an insulator.

A reaction gas passage 84 is formed between the upper electrode 81 and the gas distribution plate 82, which introduces reaction gas, which is supplied from the reaction gas plate 83, to an edge of a wafer W. In addition, an inert gas passage 86 for introducing inert gases such as nitrogen, helium and the like supplied from the inert gas pipe 85 is formed at a bottom surface adjacent to a center of the gas distribution plate 82 within a predetermined range by a baffle plate 87. Both the gas passages 84, 86 may be formed to have a circular shape in plan view.

In the mean time, the reaction gas pipe 83 and the inert gas pipe 85 may be detachably attached to inlets of the corresponding gas passages 84, 86 through adapters 88, 89, respectively. With the detachable structure of the adapters 88, 89, the upper electrode assembly 8 can be easily separated from the housing 2.

More preferably, the inert gas may be introduced into the inert gas passage 86 without the inert gas pipe 85 and the adapter 89. To this end, separate horizontal passages that communicate with the inert gas passage 86 are provided to a sidewall of the housing 2 and the upper electrode body 80. Thereby, the inert gas is directly introduced into the inert gas passage 86 through the housing 2 and the upper electrode body 80.

In addition, the reaction gas can be also introduced into the reaction gas passage 84 without the reaction gas pipe 83 and the adapter 88. To this end, an introduction hole through which the reaction gas is introduced is formed at an upper sidewall of the housing 2. Through the introduction hole, the reaction gas is directly introduced to the inside space of the housing 2. The introduced reaction gas is allowed to flow into the reaction gas passage 84 through a vertical passage.

To a bracket 12 of the housing 2 is mounted an engagement means 10 that detachably fixes the upper electrode assembly 8.

The engagement means 10 may take any shape as long as it precisely positions and fixes the upper electrode body 80. For example, a step 12 for supporting the upper electrode body 80 is formed at a position of the sidewall of the housing 2 and the upper electrode body 80 resting on the step 12 is vertically fixed with a bolt or pin. In the mean time, a through-hole into through the bolt or pin passes is formed at a corresponding part of the upper electrode body 80. In order to the fix the upper electrode body 80, a nut is used for the bolt and a clamp is used for the pin.

In addition, a diameter of the through-hole through which the bolt or pin passes may be larger than that of the bolt or pin, so as to secure a gap capable of adjusting an alignment when fixing the upper electrode body 80.

A vertically moving means 14 is disposed at a side of the housing 2. The vertically moving means 14 comprises a screw 141disposed to pass between a pair of shaft bearing parts 141, a servo motor 142 for precisely rotation-driving the screw 141 and a carrier 143 that goes up and down as the screw 141 is spirally rotated.

At a lower part of the upper electrode assembly 8 is located a lower electrode assembly 16 that vertically moves by the vertically moving means 14.

The lower electrode assembly 16 comprises a wafer chuck 160 that is disposed to be opposite to the gas distribution plate 82 and is vertically moved and a ring-shaped lower electrode 161 that is attached to a periphery of the wafer chuck 160 in an insulating manner and is disposed to be opposite to the ring-shaped upper electrode 81. The wafer chuck 160 is mounted on an upper surface of a mounting plate 163 via an insulation plate 162.

To a bottom center of the mounting plate 163 is fixed a shaft 164 extending to the outside. A longitudinal end of the shaft is integrally connected, in an orthogonal direction, to a support rod 144 extending from the carrier 143. A bellows 165 is provided to a surrounding of the shaft 164, so that an air-tight state can be maintained during the vertical movement.

At a side of the housing 2, a vent passage 20 that is opened and closed by a gate valve 18 is extended. To a longitudinal end of the vent passage is provided a dry pump 22, so that the reaction gas and inert gas supplied to the housing 2 and the particles generated by the etching are collected.

In addition, to a side of the housing 2 is provided an openable slot valve 24 that is used as a passage when loading or unloading a wafer W to or from an upper surface of the wafer chuck 160. To a lower end of the upper electrode 81 are attached a gap sensor 26 for light reception and a gap sensor 28 for light emitting, which are disposed to be opposite to each other.

The gap sensor 26 for light reception may include a CCD camera and the gap sensor 28 for light emitting may include a short wavelength lamp or laser setter having a better directionality of emitted light.

To a center of the cover 4 is provided an observation window 30 made of transparent material such as quartz or sapphire. To a center of the upper electrode assembly 8 is also provided an observation window 90. The observation windows 30, 90 are concentrically disposed.

At centers of the observation windows 30, 90 are indicated alignment marks 32, 92 such as cross shape (+), as shown in Fig. 2. Thus, it is possible to correctly check a center alignment of the wafer W with naked eyes and the like. In the mean time, the shape of the alignment mark may be diversely modified.

As another example for the observation, as shown in Fig. 3, a CCD camera 34 may be integrally mounted to the observation window 30 provided to the housing 2. Thereby, an alignment state of the wafer W loaded on the wafer chuck W is enlarged with a separate monitor, so that it is possible to check the alignment state in a more precise manner. In addition, it is possible to check the alignment state in a manner of synthesizing images photographed by the CCD camera 34 and calculating an error.

In addition, it is possible to check the alignment state through the observation window 32 while loading a wafer for alignment check having an alignment mark of a cross shape indicated at the center thereof on the wafer chuck 160 in the same condition as the real operation. At this time, when there occurs an error, it is possible to adjust an alignment of the wafer in a manner of adjusting a position or operation range of a handler (not shown) transferring the wafer W.

The plasma etching chamber having the structure as described above is operated according to following sequences.

Firstly, the center alignment state of the wafer W located on the wafer chuck 160 can be observed with naked eyes or CCD camera 34 through the observation window 30 mounted at the upper center of the cover 4 and the observation window 90 mounted to the center of the upper electrode assembly 8. Therefore, it is possible to take a measure the wafer abnormally loaded, before the etching, thereby reducing a defective proportion. In the mean time, when the cover 4 of the housing 2 is opened, it is possible to easily disassemble and assemble the upper electrode assembly from and to the housing 2.

When the center alignment of the wafer W is checked, the vertically moving means 14 elevates the lower electrode assembly 16 up to a predetermined location, so that the upper electrode 81 and an edge surface of the wafer are opposed with a gap.

During the process, the light from the gap sensor 28 for light emitting mounted at the side of the housing 2 is shaded by the wafer W of the lower electrode assembly 16 being elevating, thereby causing a change in a quantity of light. Thereby, the gap sensor 26 for light reception transmits a signal of detecting a decrease in the quantity of light. The signal is a control signal that is fed back to the servo motor 142 to control the rotation driving of the motor. In other words, the servo motor 142 is stopped with the detection signal from the gap sensor 26 for light reception, so that the upper electrode 81 is opposed to the edge upper surface of the wafer W with a predetermined gap.

According to the subsequent processes of the invention, the reaction gas is introduced to the edge of the wafer W to cause a plasma discharge and the inside of the wafer is left as a non-discharge area while being protected by the inert gas, so that only the edge of the wafer W is etched. The etching process for the edge of the wafer W is well known in the art, so that its detailed descriptions are omitted.

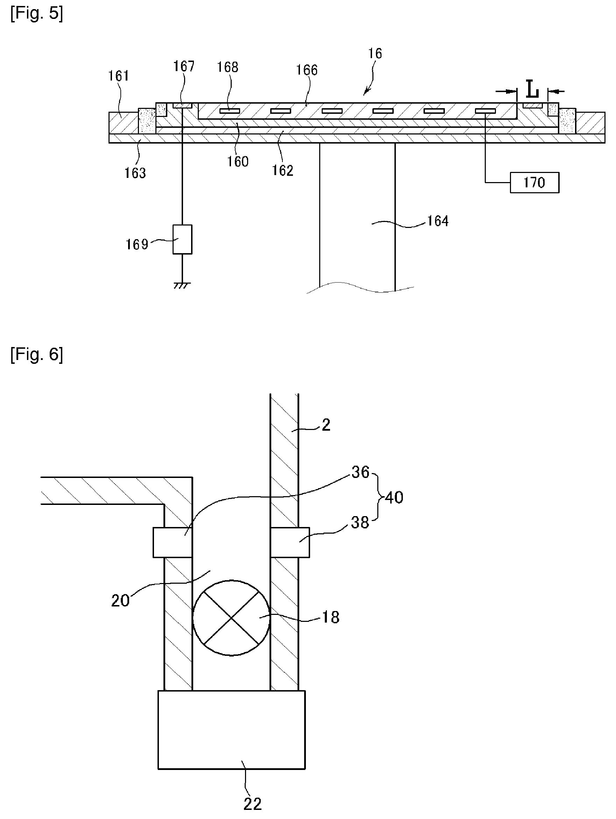

Fig. 5 is a sectional view of a wafer chuck according to the invention, and Fig. 6 shows an example of an arrangement of an in-situ monitoring tool of a plasma etching chamber according to an embodiment of the invention.

Meanwhile, in the plasma etching chamber according to the invention, the wafer chuck 160 is typically made of ceramics. Referring to Fig. 5, the wafer chuck 160 is formed to have a space therein in which a center 166 separately made of poly-imide is fitted. The poly-imide applied to the center 166 has a high surface friction coefficient. Therefore, when the wafer W is put on an upper surface of the center, there occurs no slip. Thereby, it is possible to actively suppress the alignment defective occurring when loading the wafer W and to reduce the manufacturing cost of the wafer chuck 160.

In addition, since the poly-imide has a property that is apt to be damaged by the plasma, the wafer chuck 160 is not made of poly-imide material over the entire thereof. In other words, as shown in Fig. 5, the outer surface edge and the bottom surface of the wafer chuck 160 contacting the plasma are made of ceramics and the inner part of the wafer, which does not contact the plasma, is made of poly-imide.

In addition, in the plasma etching chamber according to an embodiment of the invention, the wafer chuck 160 may consist of an electrostatic chuck. In this case, a ring-shaped discharge electrode 167 is further provided to the upper surface edge of the wafer chuck 160 and electrostatic electrodes 168 are spirally disposed in the center 166.

The edge of the wafer chuck 160 is set to have a width L of 10 mm or more so that the discharge electrode 167 is accommodated with a sufficient gap with the electrostatic electrodes 168. The discharge electrode 167 is grounded via a switching means 169 and a DC generator 170 is connected to the electrostatic electrodes 168.

While the charges electrified with the electrostatic electrodes 168 form an electrostatic field, the wafer chuck 160 serves as an electrostatic chuck chucking or de-chucking the wafer W.

More specifically, in chucking, the DC generator 170 electrifies the electrostatic electrodes 168 with positive charges, which have a polarity opposite to the charges of the wafer W, to form an electrostatic field of the positive polarity, thereby chucking the wafer W with a strong sucking force of the opposite polarity. To the contrary, in de-chucking, the DC generator 170 electrifies the electrostatic electrodes 168 with negative charges, which have a polarity same as the charges of the wafer W, thereby de-chucking the wafer W with a strong repulsive force of the same polarity.

In addition, the arrangement shape of the electrostatic electrode 168 is not limited to the spiral form.

During the chucking/de-chucking process, some of the charges applied to the electrostatic electrodes 168 are accumulated to the upper surface through the center 166. Due to the accumulated charges, the opposite bottom surface of the wafer W is electrified with the charges having the opposite polarity. Such phenomenon increases the force of chucking the wafer or serves as a force of interfering with the de-chucking.

Accordingly, when the plasma etching is completed, the switching means 169 is turned on to make the charges electrified in the bottom surface of the wafer W flow to the discharge electrode 167. The switching means 169 should be converted into a switching-off state just before the plasma etching starts. At the same time, the DC generator 170 applies the voltage, which is converted into a polarity opposite to the power applied up to now, to the electrostatic electrode 168, thereby electrifying it with the negative charges that have a polarity opposite to the positive charges electrified up to now. As a result, the upper surface of the center 166 is neutralized, so that there occurs no problem due to the remaining of the charges.

In addition, a means for automatically controlling an etching time may be provided to the plasma etching chamber according to an embodiment of the invention.

Fig. 6 shows an example of an in-situ monitoring tool 40 having a structure that a light-emitting part 36 and a light-receiving part 38 are disposed to be opposite to each other on the vent passage 20 so as to automatically control an etching time.

The in-situ monitoring tool 40 is a device that the light-receiving part 38 receives the light emitted from the light-emitting part 36 and then converts it into an electric signal. In other words, when the gas, which will be discharged through the vent passage 20, contains a large quantity of particles, the light emitted from the light-emitting part 36 is spectrally refracted and scattered, so that the quantity of light detected by the light- receiving part 38 is increased or decreased. Based on the change in the electric signal as the quantity of light is varied, the etching time is controlled. The in-situ monitoring tool 40 is not mounted only to the vent passage 20. For example, even when it is disposed side in line at the sides of the gap sensor 26 for light reception and the gap sensor 28 for light emitting, it is possible to check whether the particles remain and to control the etching time, through the gas flow between the upper electrode 81 and the upper surface of the wafer W.

By controlling the etching time, it is possible to prevent the wafer surface from being over-etched due to the plasma.

While the invention has been shown and described with reference to certain preferred embodiments thereof, it will be understood the invention as defined by the appended claims.

## Claims

1. A plasma etching chamber comprising:
a housing (2) providing a space isolated from an outside and having an upper surface opened and closed by a cover (4);
an upper electrode assembly (8) mounted in the housing (2) separated from the cover (4) so that its position is maintained when opening and closing the cover (4);
a lower electrode assembly (16) mounted below the upper electrode assembly (8) and arranged to be moveable vertically in the housing (2), the lower electrode assembly (16) being arranged such that a wafer (W) rests on it; and
means (14) arranged to move the lower electrode assembly (16) vertically,
wherein the lower electrode assembly (16) comprises a wafer chuck (160) on which the wafer (W) rests,
**characterised in that** the lower electrode assembly (16) comprises a ring-shaped lower electrode (161) that is disposed at a periphery of the wafer chuck (160); **in that**
the wafer chuck (160) is made of ceramics and has a space therein in which a center (166) formed with poly-imide is accomodated; **in that** the lower electrode assembly (16) further comprises a ring-shaped discharge electrode (167) mounted at the edge of the wafer chuck (160) and switching means (169) arranged such that the ring-shaped discharge electrode (167) is grounded via the switching means; and **in that** the lower electrode assembly (16) further comprises an electrostatic electrode (168) disposed in said center (166) and a DC generator (170) arranged such that power is applied through said DC generator (170) to chuck or de-chuck the wafer (W) with electrostatic charges.

2. The plasma etching chamber according to claim 1, further comprising an in-situ monitoring tool (40) that is disposed in a vent passage (20) of the housing (2) and is arranged to detect particles remaining in gases generated with the plasma etching, wherein
the in- situ monitoring tool (40) comprises a light-emitting part (36) and a light-receiving part (38) that are disposed to be opposite.

3. The plasma etching chamber according to claim 1, wherein the upper electrode assembly (8) rests on a step (12) formed on a side wall of the housing (2) and is fixed with an engagement means (10).

4. The plasma etching chamber according to claim 1, wherein the vertically moving means (14) comprises a shaft (164) downwardly extending from the lower electrode assembly (16) and protruding to an outside of the housing (2); a screw (141) driven by a servo motor (142); a carrier (143) vertically moving along the screw (141) as the screw (141) rotates; and a support rod (144) connecting the shaft (164) and the carrier (143).

5. The plasma etching chamber according to claim 1, wherein the upper electrode assembly (8) comprises an upper electrode body (80) detachably mounted in the housing (2), a ring-shaped upper electrode (81) fixedly attached to a bottom surface of the upper electrode body (80), a gas distribution plate (82) forming a reaction gas passage (84) at an inner side of the upper electrode (81), and a baffle plate (87) forming an inert gas passage (86) at a bottom surface of the gas distribution plate (82).

6. The plasma etching chamber according to claim 5, wherein horizontal passages that communicate with the outside and the inert gas passage (86) are provided to a sidewall of the housing (2) and the upper electrode body (80).

7. The plasma etching chamber according to claim 5, wherein an introduction hole through which the reaction gas is introduced is formed at an upper sidewall of the housing (2) and the reaction gas is directly introduced to the reaction gas passage (84) through a vertical passage formed at the upper electrode body (80).

## Patentansprüche

1. Plasmaätzkammer, die umfasst:
ein Gehäuse (2), das einen Raum bereitstellt, der gegenüber der äußeren Umgebung isoliert ist und eine obere Oberfläche besitzt, die durch eine Abdeckung (4) geöffnet und geschlossen wird;
eine obere Elektrodenanordnung (8), die in dem Gehäuse (2) montiert ist und von der Abdeckung (4) getrennt ist, so dass ihre Position beibehalten wird, wenn die Abdeckung (4) geöffnet und geschlossen wird;
eine untere Elektrodenanordnung (16), die unter der oberen Elektrodenanordnung (8) montiert ist und dafür ausgelegt ist, in dem Gehäuse (2) vertikal beweglich zu sein, wobei die untere Elektrodenanordnung (16) in der Weise ausgelegt ist, dass ein Wafer (W) auf ihr aufliegt; und
Mittel (14), die dafür ausgelegt sind, die untere Elektrodenanordnung (16) vertikal zu bewegen,
wobei die untere Elektrodenanordnung (16) eine Wafer-Einspanneinrichtung (160) umfasst, auf der der Wafer (W) aufliegt,
**dadurch gekennzeichnet, dass** die untere Elektrodenanordnung (16) eine ringförmige untere Elektrode (161) aufweist, die am Umfang der Wafer-Einspanneinrichtung (160) angeordnet ist;
dass die Wafer-Einspanneinrichtung (160) aus Keramik hergestellt ist und in sich einen Raum aufweist, in dem ein aus Polyimid gebildetes Zentrum (166) aufgenommen ist;
dass die untere Elektrodenanordnung (16) eine ringförmige Entladungselektrode (167), die an der Kante der Wafer-Einspanneinrichtung (160) montiert ist, und Schaltmittel (169), die in der Weise angeordnet sind, dass die ringförmige Entladungselektrode (167) über die Schaltmittel geerdet ist, umfasst; und
dass die untere Elektrodenanordnung (16) ferner eine elektrostatische Elektrode (168), die im Zentrum (166) angeordnet ist, und einen Gleichspannungsgenerator (170), der in der Weise ausgelegt ist, dass Leistung mittels des Gleichspannungsgenerators (170) eingegeben wird, um den Wafer (W) mit elektrostatischen Ladungen einzuspannen oder auszuspannen, aufweist.

2. Plasmaätzkammer nach Anspruch 1, die ferner ein Werkzeug (40) für eine In-situ-Überwachung umfasst, das in einem Entlüftungsdurchlass (20) des Gehäuses (2) angeordnet ist und dafür ausgelegt ist, Partikel, die in Gasen, die beim Plasmaätzen erzeugt werden, zurückbleiben, zu detektieren, wobei das Werkzeug (40) für die In-situ-Überwachung einen Lichtsendeteil (36) und einen Lichtempfangsteil (38), die einander gegenüberliegend angeordnet sind, umfasst.

3. Plasmaätzkammer nach Anspruch 1, wobei die obere Elektrodenanordnung (8) auf einer Stufe (12) aufliegt, die an einer Seitenwand des Gehäuses (2) ausgebildet ist, und mit einem Eingriffmittel (10) befestigt ist.

4. Plasmaätzkammer nach Anspruch 1, wobei die Vertikalbewegungsmittel (14) umfassen: eine Welle (164), die sich von der unteren Elektrodenanordnung (16) nach unten erstreckt und in eine äußere Umgebung des Gehäuses (2) vorsteht; eine Schraube (141), die durch einen Servomotor (142) angetrieben wird; einen Träger (143), der sich längs der Schraube (141) vertikal bewegt, wenn sich die Schraube (141) dreht; und eine Tragstange (144), die die Welle (164) und den Träger (143) verbindet.

5. Plasmaätzkammer nach Anspruch 1, wobei die obere Elektrodenanordnung (8) einen oberen Elektrodenkörper (80), der im Gehäuse (2) lösbar montiert ist, eine ringförmige obere Elektrode (81), die an einer unteren Oberfläche des oberen Elektrodenkörpers (80) fest angebracht ist, eine Gasverteilungsplatte (82), die einen Reaktionsgasdurchlass (84) an einer Innenseite der oberen Elektrode (81) bildet, und eine Ablenkplatte (87), die einen Edelgasdurchlass (86) an einer unteren Oberfläche der Gasverteilungsplatte (82) bildet, umfasst.

6. Plasmaätzkammer nach Anspruch 5, wobei horizontale Durchlässe, die mit der äußeren Umgebung und dem Edelgasdurchlass (86) kommunizieren, an einer Seitenwand des Gehäuses (2) und am oberen Elektrodenkörper (80) vorgesehen sind.

7. Plasmaätzkammer nach Anspruch 5, wobei ein Einleitungsloch, durch das das Reaktionsgas eingeleitet wird, in einer oberen Seitenwand des Gehäuses (2) ausgebildet ist und das Reaktionsgas durch einen vertikalen Durchlass, der am oberen Elektrodenkörper (80) ausgebildet ist, direkt in den Reaktionsgasdurchlass (84) eingeleitet wird.

## Revendications

1. Chambre de gravure au plasma comprenant :
un logement (2) fournissant un espace isolé de l'extérieur et comportant une surface supérieure ouverte et fermée par un élément de recouvrement (4) ;
un ensemble d'électrode supérieur (8) monté dans le logement (2) séparé de l'élément de recouvrement (4) de sorte que sa position soit maintenue lors de l'ouverture et de la fermeture de l'élément de recouvrement (4) ;
un ensemble d'électrode inférieur (16) monté au-dessous de l'ensemble d'électrode supérieur (8) et agencé pour pouvoir être déplacé verticalement dans le logement (2), l'ensemble d'électrode inférieur (16) étant agencé de sorte qu'une tranche semi-conductrice (W) repose sur celui-ci; et
des moyens (14) agencés pour déplacer l'ensemble d'électrode inférieur (16) verticalement,
dans laquelle l'ensemble d'électrode inférieur (16) comprend un plateau de tranche semi-conductrice (160) sur lequel la tranche semi-conductrice (W) repose,
**caractérisée en ce que** l'ensemble d'électrode inférieur (16) comprend une électrode inférieure de forme annulaire (161) qui est disposée au niveau d'une périphérie du plateau de tranche semi-conductrice (160) ;
**en ce que** le plateau de tranche semi-conductrice (160) est réalisé en céramique et comporte un espace dans celui-ci dans lequel un centre (166) formé par un polyimide est logé;
**en ce que** l'ensemble d'électrode inférieur (16) comprend en outre une électrode de décharge de forme annulaire (167) montée au niveau du bord du plateau de tranche semi-conductrice (160) et des moyens de commutation (169) agencés de sorte que l'électrode de décharge de forme annulaire (167) soit mise à la masse par l'intermédiaire des moyens de commutation; et
**en ce que** l'ensemble d'électrode inférieur (16) comprend en outre une électrode électrostatique (168) disposée dans ledit centre (166) et une génératrice de courant continu (170) agencée de sorte que la puissance soit appliquée par l'intermédiaire de ladite génératrice de courant continu (170) pour tenir ou relâcher la tranche semi-conductrice (W) par des charges électrostatiques.

2. Chambre de gravure au plasma selon la revendication 1, comprenant en outre un outil de surveillance sur site (40) qui est disposé dans un passage de ventilation (20) du logement (2) et qui est agencé pour détecter les particules subsistant dans les gaz générés par la gravure au plasma, dans laquelle l'outil de surveillance sur site (40) comprend une partie d'émission de lumière (36) et une partie de réception de lumière (38) qui sont disposées de manière à être face à face.

3. Chambre de gravure au plasma selon la revendication 1, dans laquelle l'ensemble d'électrode supérieur (8) repose sur un épaulement (12) formé sur une paroi latérale du logement (2) et est fixé par des moyens de mise en prise (10).

4. Chambre de gravure au plasma selon la revendication 1, dans laquelle les moyens de déplacement vertical (14) comprennent un arbre (164) s'étendant vers le bas à partir de l'ensemble d'électrode inférieur (16) et faisant saillie à l'extérieur du logement (2) ; une vis (141) entraînée par un servomoteur (142) ; un support (143) se déplaçant verticalement le long de la vis (141) alors que la vis (141) tourne; et une tige de support (144) reliant l'arbre (164) et le support (143).

5. Chambre de gravure au plasma selon la revendication 1, dans laquelle l'ensemble d'électrode supérieur (8) comprend un corps d'électrode supérieure (80) monté de manière détachable dans le logement (2), une électrode supérieure de forme annulaire (81) attachée fixement à une surface inférieure du corps d'électrode supérieure (80), une plaque de distribution de gaz (82) formant un passage de gaz de réaction (84) d'un côté intérieur de l'électrode supérieure (81), et une plaque de déflexion (87) formant un passage de gaz inerte (86) au niveau d'une surface inférieure de la plaque de distribution de gaz (82).

6. Chambre de gravure au plasma selon la revendication 5, dans laquelle les passages horizontaux qui communiquent avec l'extérieur et le passage de gaz inerte (86) sont prévus sur une paroi latérale du logement (2) et du corps d'électrode supérieure (80).

7. Chambre de gravure au plasma selon la revendication 5, dans laquelle un orifice d'introduction à travers lequel le gaz de réaction est introduit est formé au niveau d'une paroi latérale supérieure du logement (2) et le gaz de réaction est introduit directement dans le passage de gaz de réaction (84) par l'intermédiaire d'un passage vertical formé au niveau du corps d'électrode supérieure (80).
